**Europäisches Patentamt**

**European Patent Office**

**Office européen des brevets**

(11) Veröffentlichungsnummer: **0 363 984**
**A2**

## (12) EUROPÄISCHE PATENTANMELDUNG

(21) Anmeldenummer: **89119074.6**

(22) Anmeldetag: **13.10.89**

(51) Int. Cl.⁵: **G11C 8/00**

(30) Priorität: **14.10.88 DE 3835116**

(43) Veröffentlichungstag der Anmeldung:
**18.04.90 Patentblatt 90/16**

(84) Benannte Vertragsstaaten:
**DE FR GB NL**

(71) Anmelder: **Siemens Aktiengesellschaft**
**Wittelsbacherplatz 2**
**D-8000 München 2(DE)**

(72) Erfinder: **von Basse, Paul-Werner, Dipl.-Ing.**
**Margeritenstrasse 50**
**D-8190 Wolfratshausen(DE)**
Erfinder: **Dortu, Jean-Marc, Dr. rer. nat.**
**Kurfürstenstrasse 3**
**D-8000 München 40(DE)**
Erfinder: **Herlitzek, Andrea**
**Gaiglstrasse 16**
**D-8000 München 2(DE)**
Erfinder: **Kohlert, Dieter, Dipl.-Ing.**
**Erzgiessereistrasse 44**
**D-8000 München 2(DE)**
Erfinder: **Schaper, Ulrich, Dr. rer. nat.**
**Englschalkinger Strasse 222**
**D-8000 München 81(DE)**

(54) **Adressverstärkerschaltung mit Selbstverriegelung und Sicherung gegen Mehrfachadressierung zur Verwendung in statischen GaAs-RAMs.**

(57) Adreßverstärkerschaltung mit Selbstverriegelung und Sicherung gegen Mehrfachadressierung zur Verwendung in statischen GaAs-RAMs, bei der die Adresse (Adr) doppelt gespeichert wird und nur solche Signale (A, $\overline{A}$) vom Adreßverstärker an die Decoderschaltung weitergegeben werden, die keine Fehldecodierung auslösen können.

FIG 2

EP 0 363 984 A2

## Adreßverstärkerschaltung mit Selbstverriegelung und Sicherung gegen Mehrfachadressierung zur Verwendung in statischen GaAs-RAMs.

Zur Auswahl einzelner Speicherzellen in Speicherbausteinen ist es notwendig, die angelegten Adressen zu decodieren. Beim Wechsel dieser Adressen können, insbesondere bei langsamen oder gegeneinander verschobenen Schaltflanken der Adreßsignale, Zwischenzustände auftreten, bei denen zwei oder mehrere Speicherzellen gleichzeitig adressiert werden. Dies kann zu einem gegenseitigen Überschreiben der Speicherzellen und damit zu Datenverlust führen. Diese Problematik tritt besonders bei Hochgeschwindigkeitsspeichern auf, da hier die Unsicherheiten im Timing der Adreßsignale, bezogen auf die internen Schaltzeiten der Speicherbausteine, besonders groß werden.

Aus der Technik der dynamischen Speicher ist die Lösung bekannt, die Adreßdecoder durch ein zusätzliches Adreßdecoder-Freigabesignal so lange zu sperren, bis die Adreßsignale stabil an den Decodern anliegen. Erst dann wird die Decodierung freigegeben, so daß durch die nunmehr eingeschwungenen Adreßsignale nur noch ein Decoder ein Auswahlsignal liefern kann.

Aufgabe der vorliegenden Erfindung ist es, eine Adreßverstärkerschaltung mit Sicherung gegen Mehrfachadressierung zur Verwendung in statischen GaAs-RAMs anzugeben.

Diese Aufgabe wird durch die Schaltung mit den Merkmalen des Anspruchs gelöst.

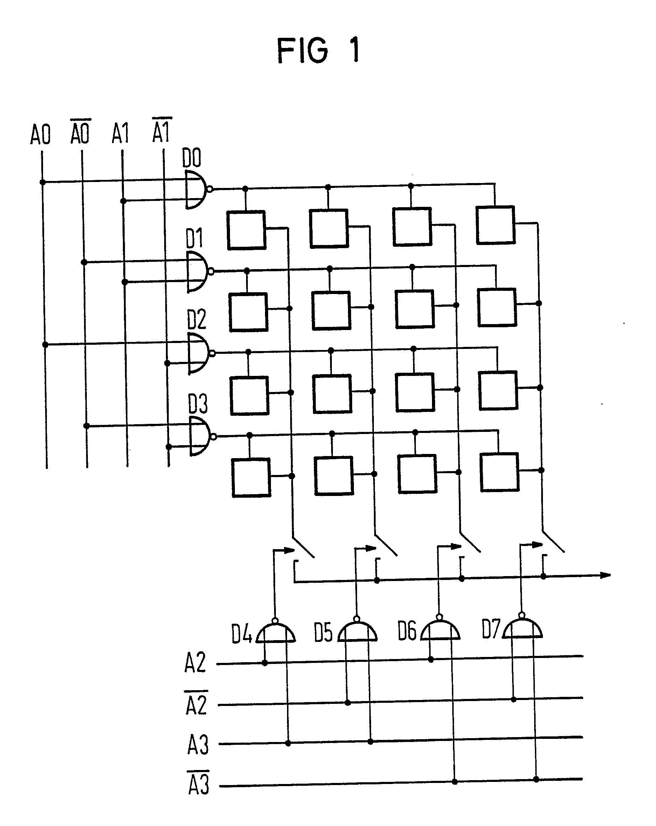

In der GaAs-DCFL (Direct Coupled FET Logic) werden die Decoder als NOR-Gatter realisiert. Figur 1 zeigt als Beispiel die Anordnung und Decodierung eines Speichers mit 16 bit x 1. Die Speicherzellen sind wie üblich in Spalten und Reihen angeord net. Eine Reihe (horizontal) ist dann ausgewählt, wenn die zugehörige Wortleitung (Ausgang der Decoder für die Reihen) eine logische "1" führt. In diesem Fall wird die Speicherzelle mit der entsprechenden internen Bitleitung' verbunden. Diese internen Bitleitungen sind über Schalter mit einer externen Bitleitung verbunden, von der aus die Verbindung mit der Außenwelt erfolgt. Es ist leicht zu erkennen, daß bei der gleichzeitigen Auswahl zweier Bit- oder Wortleitungen zwei Speicherzellen miteinander verbunden werden, was zum gegenseitigen Überschreiben der gespeicherten Information führen kann.

Es folgt eine Beschreibung der Erfindung anhand der Figuren.

Figur 1 zeigt eine schematische Darstellung eines 16 bit-Speichers mit Decodierung.

Figur 2 zeigt eine erfindungsgemäße Adreßverstärkerschaltung.

Figur 3 zeigt die erfindungsgemäße Adreßverstärkerschaltung in einer praktisch vorteilhaften Ausführung der Ausgangsstufen.

Aus Figur 1 ist zu erkennen, daß eine Decoderausgang nur dann auf "1" gehen kann, wenn alle Eingänge auf "0" liegen. Adreßbuffer stellen üblicherweise nur kräftig dimensionierte Inverter dar, die das Adreßsignal und seine Negation zu den Decodern weiterleiten. Undefinierte Zustände während des Adreßwechsels werden deshalb an die Decoder weitergeleitet.

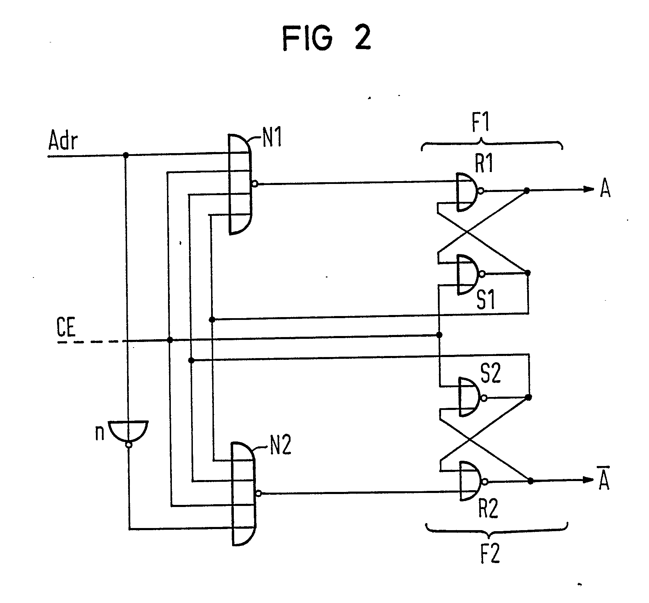

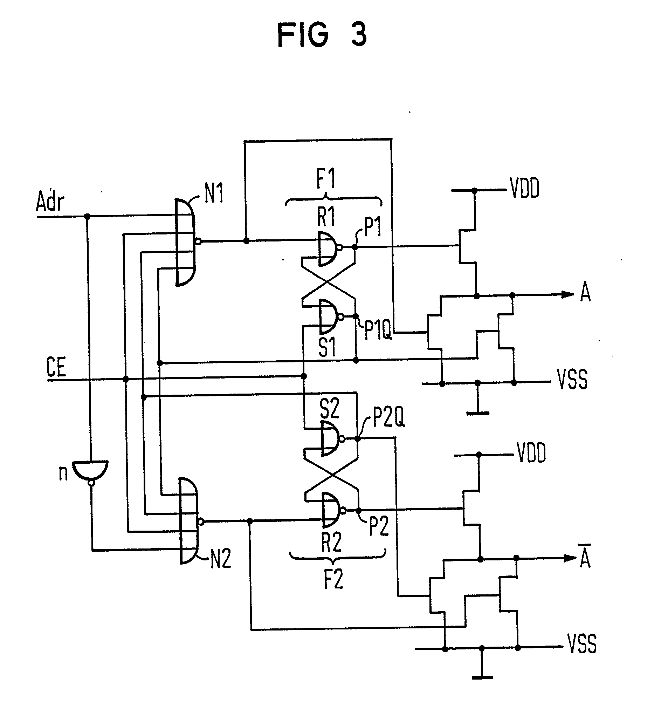

Um die Weiterleitung undefinierter Zustände an die Adreßbuffer verhindern zu können, wird ein Chip-enable-Signal benötigt, das dem Baustein signalisiert, ob er sich im Wartezustand befindet oder ob ein Schreib- oder Lesevorgang stattfindet. Die Polarität dieses Signals ist üblicherweise so definiert, daß eine High-Pegel den Pausenzustand signalisiert und ein Low-Pegel den aktiven (Lese- oder Schreib-) Zustand. Dieses Signal steuert die Adreßbuffer, die nun nicht mehr als Inverter ausgeführt werden, sondern aus zwei Speicherelementen mit folgenden Eigenschaften aufgebaut sind (Figuren 2 und 3):

1. Während der Pause führen alle Adreßpufferausgänge High-Potential.

2. Mit der abfallenden Flanke des Chip-enable-Signals werden die Adressen eingelesen und an die Adressdecoder weitergeleitet. Mit dem Ende einer Speicheraktivierung, also mit ansteigender Chip-enable-Flanke, werden alle Adreßbufferausgänge wieder auf High-Potential geschaltet.

Diese Art der Decoderansteuerung bewirkt, daß nur die Adreßbufferausgänge, die eine logische "0" übertragen sollen, ihren Zustand ändern. Da, wie aus Figur 1 ersichtlich, eine Leitung mit High-Potential alle angeschlossenen Decodergatter blokkiert, bestimmt die letzte der Adreßbufferausgangsleitungen, die auf Low-Potential kippt, welche Wortleitung ausgewählt wird. Undefinierte Zustände mit mehreren gleichzeitig ausgewählten Wortleitungen können somit nicht mehr auftreten.

Für die Übernahme der Adressen mit der abfallenden Flanke des Chip-enable-Signals wird eine selbstverriegelnde Technik gewählt (Figur 2): Mit dem Low-Pegel des Chip-enable-Signals werden Tore zu den Adreß-Latches geöffnet, so daß, abhängig von der Polarität des Adreßsignals, jeweils eines der beiden zu einer Adreßleitung gehörenden Adreß-Latches einen Setzimpuls erhält und umkippt. Das Ausgangssignal des gekippten Adreß-Latches blockiert seinerseits die Tore, so daß die Adreßinformation jetzt gespeichert ist, unabhängig von nachfolgenden Änderungen der Pegel auf den Adreßleitungen. Mit dem Beginn der Pause erhalten die Adreß-Latches durch den High-Pegel des Chip-enable-Signals ein Reset-Signal, das beide Ausgänge auf High-Potential schaltet. Figur 2 zeigt ein Prinzipschaltbild dieser Anordnung.

Figur 3 zeigt die praktische Ausführung der Adreßverstärkeranordnung mit zusätzlichen Maßnahmen zur Laufzeitoptimierung. Die Ausgangsstufen, welche die Decoderleitungen zu treiben haben, sind als Push-pull-Stufe aus Normally-off-Transistoren ausgeführt. Der für die Zugriffszeit kritische Zeitraum ist die Zeit von der abfallenden Flanke des Chip-enable-Signals bis zur abfallenden Flanke eines der beiden Ausgangssignale.

Dieser Zeitraum wird dadurch verkürzt, daß die Signale Z und Y direkt zur Push-pull-Stufe geleitet werden. Dadurch wird die Ausgangsleitung schon nach unten gezogen, bevor das Adreß-Latch die Information nach zwei Gatterlaufzeiten gespeichert hat ($A_i$ eher auf "low" als PIQ auf "High").

## Ansprüche

Adreßverstärkerschaltung für statische RAMs mit einer Adreßsignalleitung (Adr), einer ersten Ausgangssignalleitung (A) und einer zweiten Ausgangssignalleitung ($\overline{A}$), **dadurch gekennzeichnet,**

- daß ein erstes Flipflop (F1) mit einem ersten Reset-Schaltglied (R1) und einem ersten Set-Schaltglied (S1) und ein zweites Flipflop (F2) mit einem zweiten Reset-Schaltglied (R2) und einem zweiten Set-Schaltglied (S2) vorhanden sind,
- daß ein erstes NOR-Schaltglied (N1) und ein zweites NOR-Schaltglied (N2) vorhanden sind,
- daß eine Chip-enable-Signalleitung (CE) vorhanden ist,
- daß die Chip-enable-Signalleitung (CE) mit einem jeweiligen Eingang des ersten NOR-Schaltgliedes (N1), des zweiten NOR-Schaltgliedes (N2), des ersten Set-Schaltgliedes (S1) und des zweiten Set-Schaltgliedes (S2) verbunden ist,
- daß die Adreßsignalleitung (Adr) mit einem Eingang des ersten NOR-Schaltgliedes (N1) und über ein Negationsglied (n) mit einem Eingang des zweiten NOR-Schaltgliedes (N2) verbunden ist,
- daß die Ausgänge des ersten Set-Schaltglieds (S1) und des zweiten Set-Schaltgliedes (S2) jeweils mit einem jeweiligen Eingang des ersten NOR-Schaltgliedes (N1) und des zweiten NOR-Schaltgliedes (N2) verbunden sind,
- daß der Ausgang des ersten NOR-Schaltgliedes (N1) mit einem Eingang des ersten Reset-Schaltgliedes (R1) und der Ausgang des zweiten NOR-Schaltgliedes (N2) mit einem Eingang des zweiten Reset-Schaltgliedes (R2) verbunden ist und
- daß der Ausgang des ersten Reset-Schaltgliedes (R1) auf eine erste Ausgangssignalleitung (A) und der Ausgang des zweiten Reset-Schaltgliedes (R2) auf eine zweite Ausgangssignalleitung ($\overline{A}$) führt.

FIG 1

# FIG 2

# FIG 3